**Europäisches Patentamt**

**European Patent Office**

**Office européen des brevets**

(19)

(11) Veröffentlichungsnummer : **0 384 022 B1**

(12)

# EUROPÄISCHE PATENTSCHRIFT

(45) Veröffentlichungstag der Patentschrift :
**11.03.92 Patentblatt 92/11**

(51) Int. Cl.⁵ : **H01T 19/04**

(21) Anmeldenummer : **89123069.0**

(22) Anmeldetag : **13.12.89**

(54) **Hochspannungselektrodenanordnung.**

(30) Priorität : **24.02.89 DE 3905799**

(43) Veröffentlichungstag der Anmeldung :
**29.08.90 Patentblatt 90/35**

(45) Bekanntmachung des Hinweises auf die
Patenterteilung :
**11.03.92 Patentblatt 92/11**

(84) Benannte Vertragsstaaten :
**AT BE CH DE FR GB IT LI LU NL SE**

(56) Entgegenhaltungen :
**DE-A- 2 343 483**
**DE-A- 2 713 334**
**DE-A- 3 049 484**

(56) Entgegenhaltungen :
**DE-A- 3 347 600**
**DE-A- 3 619 178**
**FR-A- 2 107 343**
**FR-A- 2 296 958**

(73) Patentinhaber : **Eltex-Elektrostatik**
**Gesellschaft mbH**
**Postfach 1229 Neudorfer Strasse 5**
**W-7858 Weil am Rhein (DE)**

(72) Erfinder : **Domschat, Klaus**
**Untersdorf Strasse 3**
**W-7850 Lörrach (DE)**

(74) Vertreter : **Säger, Manfred, Dipl.-Ing. et al**
**Säger & Partner Postfach 81 08 09**
**W-8000 München 81 (DE)**

EP 0 384 022 B1

**Beschreibung**

Die Erfindung betrifft eine Hochspannungselektrodenanordnung gemäß dem Oberbegriff des Hauptanspruchs.

Eine derartige Hochspannungselektrodenanordnung ist bekannt (DE-A-30 49 484 A1). Die bekannte Elektrodenanordnung besteht aus einer Vielzahl von zueinander parallel angeordneten Einzelelektroden, die alle miteinander elektrisch verbunden sind. Diese Elektrodenanordnung besteht aus einem Vollisolierkörper, der durch einen einen Zellenaufbau aufweisenden elektrischen Isolierstoff gebildet ist und der flexibel jedoch biegesteif ist, wobei die Einzelelektroden senkrecht zur Längserstreckung der Anordnung ausgerichtet sind und über dessen eine Längskante mit ihre Spitze überstehen. Ebenfalls in Längserstreckung ist ein elektrischer Leiter angebracht.

Diese Elektrodenanordnung auf einem langgestreckten, elastisch formbaren (biegsamen) Band vorzusehen, ist ebenfalls bekannt (FR-A-2 296 958).

Die Herstellung derartiger Hochspannungselektrodenanordnungen ist einerseits recht aufwendig und bietet, falls die Hochspannungselektrodenanordnung zwei gesondert schaltbare Gruppen von Einzelelektroden aufweisen sol 1, keine ausreichende Sicherheit gegen Durchschlagsspannungen und keinen Schutz gegen Spannungsspitzen.

Der Erfindung liegt die Aufgabe zugrunde, eine gattungsgemäße Hochspannungelektrodenanordnung weniger aufwendig herzustellen unter gleichzeitiger Sicherheitserhöhung gegen Kurzschlüsse und Spannungsspitzen.

Diese Aufgabe wird bei einer gattungsgemäßen Hochspannungselektrodenanordnung gemäß dem Oberbegriff des Hauptanspruches erfindungsgemäß durch dessen kennzeichnende Merk male gelöst.

Erfindungsgemäß ergibt sich also ein langgestrecktes, elastisch formbares Band aus einem elektrisch isolierenden Werkstoff, vorzugsweise eine Isolationsträgerfolie mit hoher Durchschlagsspannungsfestigkeit, die zumindest einen parallel zur Längserstreckung des Bandes verlaufenden Leiter, aorzugsweise eine aufgebrachte oder integrierte Leiterbahn auf einer Flachseite des Bandes aufweist, an die an eine Vielzahl bzr. Gruppen von Einzelelektroden angeschlossen sind, die senkrecht zur Längserstreckung des Bandes verlaufen und mit ihrer Spitze über eine Längskante des Bandes überstehen, wobei die Elektroden an dem Leiter angelötet oder angekrimpt sein können. Es ist aber auch möglich, daß das Band aus zwei kongruenten Teilbändern besteht, die zwischen sich die Einzelelektroden aufnehmen, wobei eines oder beides der Teilbänder zum Anschluß ausgespart sein können.

Mit diesem Grundprinzip der Erfindung ist es möglich, keine starre, sondern eine nahezu endlos herstellbare Elektrode nanordnung herzustellen, die nach ihrer Herstellung aufgerollt werden kann, so daß bei Bedarf nur eine bestimmte Länge der Elektrode nanordnung gerollt werden muß, je nach Forderungen des Einbaumaßes. Außerdem ist die Elektrode nanordnung und elastisch und kann beispielsweise auch in gekrümmter Form für komplizierte Anwendungszwecke eingesetzt werden. Im übrigen läßt sich die erfindungsgemäße Hochspannungselektrode nanordnung zumindest halbautomatisch herstellen, wodurch die Gestehungskosten erheblich verringert sind.

Wenn die Hochspannungselektrode nanordnung zwei gesondert schaltbare Gruppen von Einzelelektroden aufweisen soll, so können je ein Leiter auf einer der beiden Flachseiten des Bandes angebracht werden, die dann mit den Elektroden verbunden sind. Aufgrund der hohen Durchschlagsspannungsfestigkeit der Folie selbst ist das gesonderte Vergießen nach dem Stande der Technik entbehrlich.

Wenn die Hochspannungselektrode Widerstände aufweisen soll, so können diese senkrecht zur Längserstreckung als diskrete Bauelemente angebracht werden. In vorteilhafter Ausgestaltung der Erfindung sind die Widerstände aber als Keramiksubstratwiderstände ausgebildet, wobei das Substrat im wesentlichen rechteckförmigen Umriß aufreist und mit seiner einen Seite an die Einzelelektrode und mit seiner anderen Seite mit dem Leiter verbunden und selbst auf die Flachseite des Bandes aufgeklebt ist.

In vollautomatischer Herstellung wird nicht nur die Leiter als Leiterbahn auf eine Flachseite des Bandes aufgebracht, sondern ebenfalls der Widerstand und/oder Kondensator als SMD (Surface Mounted Device) aufgebracht. Die Spitzen werden gegurtet zugeführt und automatisch an den Widerstand angekrimpt.

Weitere zweckmäßige Ausgestaltungen und Weiterbildungen der Erfindung sind in den Unteransprüchen gekennzeichnet.

Ein bevorzugtes Ausführungsbeispiel der Erfindung ist nachfolgend unter Bezugnahme auf die Zeichnung näher erläutert. In dieser zeigt:

Figur 1 eine erfindungsgemäße Hochspannungselektrode, in schematischer perspektivischer Ansicht;
Figur 2 einen Schnitt II-II gemäß Fig. 1;
Figur 3 die Einzelheit III gemäß Fig. 1; und
Figur 4 einen Schnitt IV-IV gemäß Fig. 1.

Die insgesamt mit 5 bezeichnete Hochspannungselektrode anordnung weist eine Vielzahl von zueinander parallel angeordneten Einzelelektroden 6 auf, die an einem langgestreckten, elastisch formbaren Band 7 aus einem elektrisch isolierenden Werkstoff, vorzugsweise einer Isolationsträgerfolie mit hoher Durchschlagsspannungsfestigkeit an dessen einer Flachseite 8 so angeordnet sind, daß sie über dessen - obere Längskante 9 vorspringen.

Ferner ist auf der einen Flachseite 8 der beiden Flachseiten des Bandes 7 nahe der - oberen gegenüberliegenden unteren - Längskante 10 ein Leiter 11 in Form einer aufgedruckten Leiterbahn vorgesehen. Zwischen der Leiterbahn und der genannten - oberen - Längskante 9 des Bandes 7 ist ein insgesamt mit 12 bezeichneter, als Keramiksubstratwiderstand ausgebildeter Widerstand angeordnet, der - in Draufsichteinen rechteckförmigen Umriß aufweist, wobei die Schmalseiten des Rechtecks parallel zu den beiden Längskanten g, 10 des Bandes 7 und die langen Kanten parallel zu dem senkrecht zur Längserstreckung des Bandes verlaufenden Einzelelektroden 6 angeordnet sind. Der Keramiksubstratwiderstand 12 ist an seinem unteren Ende, beispielsweise mittels einer Lötverbindung 13 elektrisch mit dem Leiter 11 verbunden.

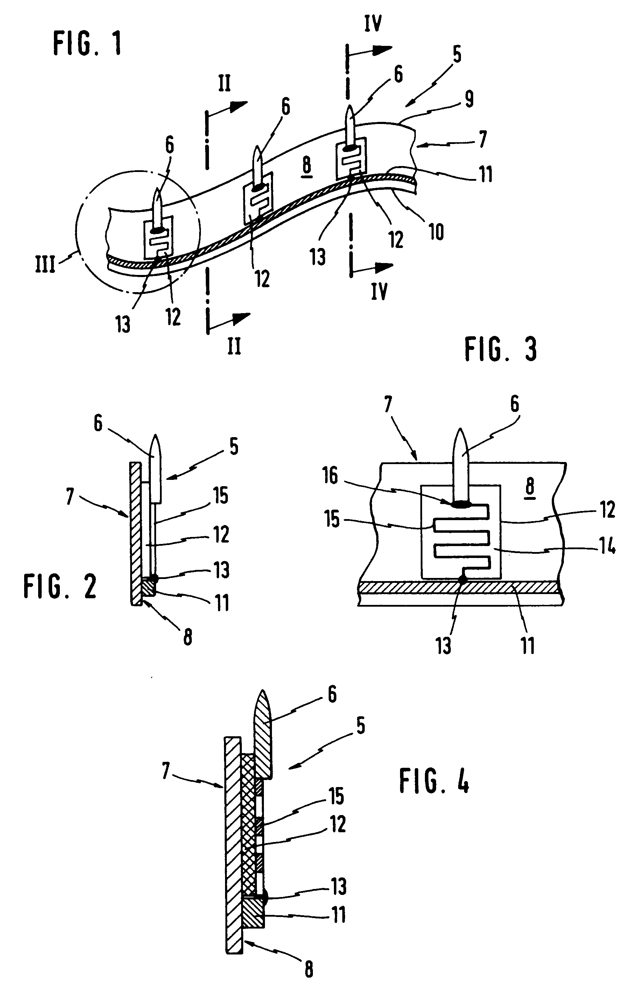

Der Keramiksubstratwiderstand 12 ist in Fig. 3 in Draufsicht näher gezeigt. Er weist ein Keramikplättchen 14 mit auf dessen Oberseite ein mäanderförmiges, den eigentlichen Widerstand bildendes Substrat 15 auf. Im oberen Bereich des Keramiksubstratwiderstandes 12 ist am Ende des Substrates 15 die Einzelelektrode 6 befestigt, beispielsweise angelötet, vorzugsweise aber angekrimpt. Am unteren Ende des Substrates 15 ist mit 13 schematisch die Lötverbindung mit dem Leiter 11 gezeigt.

Figuren 2 und 3 zeigen verschiedene Querschnitte durch die insgesamt mit 5 bezeichnete Hochspannungselektrode anordnung, wobei ersichtlich ist, daß der Keramiksubstratwiderstand 12 auf die eine Flachseite 8 des Bandes 7 aufgebracht, Vorzugsweise aufgeklebt ist. Auf dem an sich bekannten Keramiksubstratwiderstand 12 ist auf dessen einer ebenen Vorderseite das mäanderförmige Substrat 15 aufgebracht, die Rückseite vorzugsweise durch Kleben mit der einen Flachseite 8 des Bandes 7 verbunden.

## Patentansprüche

1. Hochspannungselektrodenanordnung (5) mit einer Vielzahl von zueinander parallel angeordneten Einzelelektroden (6), die miteinander elektrisch verbunden sind, bestehend aus einem aus einem elektrisch isolierenden Werkstoff bestehenden Trägermaterial, auf dem die Einzelelektroden (6) senkrecht zur Längserstreckung des Trägermaterials angeordnet sind und über dessen eine Längskante (9) mit ihrer Spitze überstehen, wobei in Längserstreckung des Trägermaterials ein elektrischer Leiter aufgebracht ist, **dadurch gekennzeichnet,**

– daß das Trägermaterial ein langgestrecktes elastisch formbares Band (7) ist, das eine hohe Durchschlagfestigkeit aufweist,

– daß die Einzelektroden (6) gruppenweise oder alle miteinander auf dem Band über den Leiter (11) verbunden sind, und

– daß zwishen dem Leiter (11) und jeder Einzelzktrode (6) ein - komplexer - Widerstand (12), das heißt Ohm'scher Widerstand, Kapazität oder Induktivität, angeordnet ist.

2. Hochspannungselektrode nanordnung nach Anspruch 1, dadurch gekennzeichnet, daß das der Spitze jeder Einzelelektrode (6) gegenüberliegende Ende an den Leiter (11) angeschlossen ist.

3. Hochspannungselektrode nanordnung nach Anspruch 1 oder 3, dadurch gekennzeichnet, daß das Band (7) eine Isolationsträgerfolie ist.

4. Hochspannungselektrode nanordnung nach einem der Ansprüche 1 bis 3, dadurch gekennzeichnet, daß das Band (7) aus zwei kongruenten Teilbändern besteht, die zwischen sich die Einzelelektroden (6) aufnehmen und zu deren Anschluß ein Teilband ausgespart ist.

5. Hochspannungselektrode nanordnung nach einem der Ansprüche 1 bis 4, dadurch gekennzeichnet, daß der Widerstand als Keramiksubstratwiderstand (12) ausgebildet ist.

6. Hochspannungselektrode nanordnung nach einem der Ansprüche 1 bis 5, dadurch gekennzeichnet, daß der Keramiksubstratwiderstand 12) im wesentlichen rechteckförmigen Umriß aufweist, an seiner einen Seite die Einzelelektrode (6) aufweist und an seiner anderen Seite mit dem Leiter (11) verbunden ist.

7. Hochspannungselektrode nanordnung nach einem der Ansprüche 1 bis 6, dadurch gekennzeichnet, daß der Keramiksubstratwiderstand (12) auf die Flachseite (8) des Bandes (7) aufgeklebt ist.

8. Hochspannungselektrode nanordnung nach einem der Ansprüche 1 bis 7, dadurch gekennzeichnet daß der Leiter (11) auf zumindest einer der beiden Flachseiten (8) des Bandes (7) als Leiterbahn aufgebracht, vorzugsweise aufgedruckt ist.

9. Hochspannungselektrode nanordnung nach einem der Ansprüche 1 bis 8, dadurch gekennzeichnet, daß die Wiederstände (12) auf zuminsdest eine der beiden Flachseiten (8) des Bandes (7) aufgedruckt sind.

EP 0 384 022 B1

10. Hochspannungselektrode nanordnung nach einem der Ansprüche 1 bis 9, dadurch gekennzeichnet, daß die Einzelelektroden (6) an das eine Ende des Widerstandes (12) aufgekrimpt sind.

11. Hochspannungselektrode nanordnung nach einem der Ansprüche 1 bis 10, dadurch gekennzeichnet, daß aktive elektrische und/oder elektronische Schaltungen auf zumindest einer Seite des Bandes (7) angeordnet und an den elektrischen Leiter (11) angeschlossen sind.

12. Hochspannungselektrode nanordnung nach Anspruch 11, dadurch gekennzeichnet, daß die aktiven Schaltungen eine Hochspannungskaskaden-, Meß- und/oder Steuerschaltung umfaßt.

**Claims**

1. High-voltage electrode arrangement (5) with a number of individual electrodes (6) arranged parallel to one another and electrically connected together, comprising a carrier material made of an electrically insulating material, on which the individual electrodes (6) are arranged perpendicular to the longitudinal extent of the carrier material and with their tips projecting beyond its longitudinal edge (9), an electric conductor being applied along the longitudinal extent of the carrier material characterised in that
   – the carrier material is a longitudinally extending elastically deformable strip (7) having a high resistance to breakdown,
   – the individual electrodes (6) are connected together in groups or all together on the strip by the conductor (11), and
   – between the conductor (11) and each individual electrode (6) there is arranged a complex impedance (12) that is to say an ohmic resistor, capacitor or inductance.

2. High-voltage electrode arrangement according to claim 1, characterised in that the end of each individual electrode (6) opposite its tip is connected to the conductor (11).

3. High-voltage electrode arrangement according to claim 1 or 2 characterised in that the strip (7) is an insulating carrier sheet.

4. High-voltage electrode arrangement according to one of claims 1 to 3 characterised in that the strip (7) comprises two matching part-strips which receive the individual electrodes (6) between them and for the connection of which a part-strip is cut away.

5. High-voltage electrode arrangement according to one of claims 1 to 4 characterised in that the impedance is in the form of a ceramic substrate resistor (12).

6. High-voltage electrode arrangement according to one of claims 1 to 5 characterised in that the ceramic substrate resistor (12) has a substantially rectangular outline with the individual electrode (6) connected to its one side and connected at its other side to the conductor (11).

7. High-voltage electrode arrangement according to one of claims 1 to 6 characterised in that the ceramic substrate resistor (12) is caused to adhere to the flat face (8) of the strip (7).

8. High-voltage electrode arrangement according to one of claims 1 to 7 characterised in that the conductor (11) is applied as a conducting path, preferably by printing, onto at least one of the two faces (8) of the strip (7).

9. High-voltage electrode arrangement according to one of claims 1 to 8 characterised in that the impedances (12) are printed on at least one of the two faces (8) of the strip (7).

10. High-voltage electrode arrangement according to one of claims 1 to 9 characterised in thai the individual electrodes (6) are crimped onto the one end of the impedance (12).

11. High-voltage electrode arrangement according to one of claims 1 to 10 characterised in that active electrical and/or electronic circuits are arranged on at least one side of the strip (7) and connected to the electric conductor (11).

12. High-voltage electrode arrangement according to one of claims 1 to 11 characterised in that the active circuits include a high-voltage cascade measuring and/or control circuit.

**Revendications**

1. Structure d'électrodes haute tension (5) comportant une pluralité d'électrodes isolées (6) disposées parallèlement lesquelles sont reliées électriquement les unes aux autres, constituée d'un matériau support réalisé en un matériau électriquement isolant sur lequel les électrodes isolées (6) sont disposées perpendiculairement à l'extension longitudinale du matériau support, leurs pointes faisant saillie d'une arête longitudinale (9) de celui-ci, tandis qu'en extension longitudinale dudit matériau support est fixé un conducteur électrique, caractérisée par le fait :

4

– que le matériau support est une bande (7) s'étendant en longueur, pouvant être élastiquement façonnée, qui présente une résistance disruptive élevée,

– que les électrodes isolées (6) sont reliées les unes aux autres par groupes ou toutes ensembles sur la bande par le conducteur (11), et

– que, entre le conducteur (11) et chaque électrode isolée (6), est disposée une résistance complexe, c'est-à-dire une résistance ohmique, une capacitance ou une inductance.

2. Structure d'électrodes haute tension selon la revendication 1, caractérisée par le fait que l'extrémité opposée à la pointe de chaque électrode isolée (6) est raccordée sur le conducteur (11).

3. Structure d'électrodes haute tension selon la revendication 1 ou 2, caractérisée par le fait que la bande (7) est un film support isolant.

4. Structure d'électrodes haute tension selon l'une des revendications 1 à 3, caractérisée par le fait que la bande (7) est constituée de deux bandes partielles identiques et symétriques qui réceptionnent les électrodes isolées (6) dans leur interstice, l'une de ces bandes partielles présentant une encoche pour la connexion électrique.

5. Structure d'électrodes haute tension selon l'une des revendications 1 à 4, caractérisée par le fait que la résistance est réalisée sous la forme d'une résistance (12) à substrat céramique.

6. Structure d'électrodes haute tension selon l'une des revendications 1 à 5, caractérisée par le fait que la résistance (12) à substrat céramique présente un contour extérieur sensiblement rectangulaire, l'électrode isolée (6) étant montée sur l'un de ses côtés et l'autre de ses côtés étant relié au conducteur (11).

7. Structure d'électrodes haute tension selon l'une des revendications 1 à 6, caractérisée par le fait que la résistance (12) à substrat céramique est collée sur le côté plat (8) de la bande (7).

8. Structure d'électrodes haute tension selon l'une des revendications 1 à 7, caractérisée par le fait que le conducteur (11) est fixé, de préférence par impression, sur au moins l'un des deux côtés plats (8) de la bande (7) en constituant une bande conductrice.

9. Structure d'électrodes haute tension selon l'une des revendications 1 à 8, caractérisée par le fait que les résistances (12) sont imprimées sur au moins l'un des deux côtés plats (8) de la bande (7).

10. Structure d'électrodes haute tension selon l'une des revendications 1 à 9, caractérisée par le fait que les électrodes isolées (6) sont fixées par sertissage sur une extrémité de la résistance (12).

11. Structure d'électrodes haute tension selon l'une des revendications 1 à 10, caractérisée par le fait que des circuits électriques et/ou électroniques actifs sont disposés sur au moins un côté de la bande (7) et raccordés au conducteur électrique (11).

12. Structure d'électrodes haute tension selon la revendication 11, caractérisée par le fait que les circuits actifs comprennent un circuit à haute tension en cascade de mesure et/ou de commande.

FIG. 1

FIG. 2

FIG. 3

FIG. 4